# EUROPEAN PATENT APPLICATION

(11) **EP 4 730 940 A1**
(43) Date of publication of application: **22.04.2026**
(21) Application number: 25207705.2
(22) Date of filing: 09.10.2025
(51) Int. Cl.: H05K 7/20

(54) **ELECTRONIC UNIT FOR A VEHICLE AND CORRESPONDING ASSEMBLY METHOD**

(30) Priority: 18.10.2024 IT 202400023274
(71) Applicant: Marelli Europe S.p.A., 20011 Corbetta (MI) (IT)
(72) Inventor: BOERO, Flavio, I-20011 Corbetta (Milano) (IT)
(74) Representative: Buzzi, Notaro & Antonielli d'Oulx S.p.A.

(57) **Abstract**

An electronic unit (1) for vehicles, comprising a casing (15) housing therewithin:
- at least one electronic module (100),
- at least one electronic board (3A, 3B) carrying said at least one electronic module (100),
- a frame (7) releasably connected to said at least one board (3A, 3B),
- a first cooling system (25) configured to cool down said at least one electronic module (100), comprising a heatsink (27) and a ventilation device (29) configured to convey an air flow through said heatsink (27),

characterized in that said frame (7) comprises a shaped portion (43) defining a second heatsink (45) configured to provide heat exchange with said at least one electronic module (100),
wherein said shaped portion (43) of the frame (7) defining said second heatsink (45) comprises at least one channel (47; 51, 65, 67) in fluid communication with an environment external to said casing (15) of the electronic unit (1).

## Description

### Technical field

The description relates to the field of electronic units for vehicles. In particular, the present solution refers to on-board electronic units that exchange data with peripherals of the vehicle and the data exchanged.

### Technological background

In the automotive industry, the aforementioned type of electronic unit is generally used to control one or more appliances of the vehicle.

In order to do so, the electronic unit has one or more modules configured to exchange data with systems of the vehicle external to the electronic unit, for instance sensors associated with respective devices of the vehicle or other electronic units. The one or more modules may also comprise a processor module configured to process the data exchanged with said systems.

Moreover, the electronic units known in the art generally comprise at least one electronic board configured to carry the aforementioned modules and to implement the electrical connections among the modules of the electronic unit.

As known per se, during operation of the electronic unit, the modules may heat up reaching high temperature, for instance in the range comprised between 80 and 110 °C, which can cause damages or malfunctioning of the electronic unit itself.

Thereby, it is required to provide a system for cooling down the modules.

In this regard, the electronic unit described in document IT 102017000104682 of the same Applicant, comprises a cooling system including a heatsink and a ventilation device, in the form of a fan, associated therewith.

In this solution, the heat dissipation is achieved by creating a convective heat transfer between the heatsink, which has a laminated structure defining a plurality of passages, and an incident air flow conveyed by the fan through said passages.

The electronic unit disclosed in IT 102017000104682, further comprises a frame made of polymeric material, for instance a combination of polycarbonate and Acrylonitrile-butadiene-styrene (so-called ABS), releasably connected to the electronic board, and an outer casing defining the outer walls of the electronic unit and configured to receive said modules, said electronic board and said cooling system therewithin.

With reference to the aforementioned solution, and more in general to the electronic units known in the art, the applicant has identified a series of drawbacks.

As a matter of fact, the increasing performances of the recent modules used in the automotive field of application, and consequently a greater power required during the operation of the electronic unit, lead inevitably to a higher amount of heat released by the modules within the electronic unit, therefore requiring a more efficient heat dissipation.

This problem is further intensified by the more and more stringent requirements related to the simplicity and dimension of the electronic units.

### Object and summary

An object of one or more embodiments is to contribute in providing solutions which allow a more efficient heat dissipation in an electronic unit for a vehicle.

According to one or more embodiments, that object is achieved via an electronic unit for a vehicle having the features set forth in the claims that follow.

The claims are an integral part of the technical teaching provided in respect of the embodiments.

Solutions as described herein include an electronic unit for vehicles, comprising a casing housing therewithin:
- at least one electronic module,
- at least one electronic board carrying the at least one electronic module,
- a frame releasably connected to the at least one board,
- a first cooling system configured to cool down the at least one electronic module, comprising a heatsink and a ventilation device configured to convey an air flow through the heatsink,

characterized in that the frame comprises a shaped portion defining a second heatsink configured to provide heat exchange with the at least one electronic module,
wherein the shaped portion of the frame defining the second heatsink comprises at least one channel in fluid communication with an environment external to the casing of the electronic unit.

In various embodiments, the frame is made of metallic material, preferably Aluminum or Magnesium alloy.

In various embodiments, the electronic unit comprises a second cooling system including the shaped portion defined by the frame and a second ventilation device associated therewith and configured to convey an air flow through the at least one channel defined by the frame.

In various embodiments, the at least one channel defined by said frame includes an inlet port in fluid communication with an environment external to the electronic unit,
wherein the inlet port is arranged facing the second ventilation device so as to receive an air flow from the second ventilation device,
the at least one channel comprising an outlet port arranged in fluid communication with an environment external to the electronic unit,
the outlet port being arranged downstream with respect to the inlet port, and configured for the exhaust of the air flow conveyed therethrough to the outside of said electronic unit.

In various embodiments, the at least one channel is an open channel having a substantially U-shaped geometry.

In various embodiments, the frame comprises:
- at least one surface,
- at least one rib and/or at least one ridge protruding with respect to said surface,
the at least one rib and/or at least one ridge and said surface delimiting said at least one channel laterally and at the bottom respectively, thereby defining said substantially U-shaped geometry of the at least one channel.

In various embodiments, the at least one electronic board comprises a first and a second electronic board arranged at opposite sides of the frame.

In various embodiments, the frame comprises at least one platform, the platform defining a contact surface configured to abut a respective module of the at least one module in an assembled configuration of the electronic unit In various embodiments, the platform comprises a thermal pad arranged on a free end thereof, the thermal pad defining the aforesaid contact surface.

In various embodiments, the casing comprises a first metal part and a second metal part, each metal part being releasably connected to said frame.

In various embodiments, the first and the second electronic boards, the first and the second metal parts are releasably connected to the frame by means of a plurality of fixing elements arranged at peripheral portions of the frame.

In various embodiments, the plurality of fixing elements comprises:
- a first group of fixing elements configured to connect the first electronic board and the first metal part to the frame,
   the first fixing elements extending through respective through holes arranged on the frame and on the first electronic board and engaging respective fixing seats arranged on the first metal part,
- a second group of fixing elements configured to connect the second electronic board and the second metal part to the frame,
the second fixing elements extending through respective through holes arranged on the second metal part and on the second electronic board, and engaging respective fixing seats arranged on the frame.

In various embodiments, the electronic module comprises a module configured to exchange data with systems external to the electronic unit and/or process said data.

The solution described herein also refers to a method for assembling an electronic unit, the method comprising:
- providing the first metal part,
- stacking the first electronic board and the frame on the first metal part, so that the first electronic board is arranged between the first metal part and the frame,

- connecting the frame to the first metal part via the first group of fixing elements,
   wherein connecting the frame to the first metal part comprises inserting the first group of fixing elements through the through holes of the frame along a first direction of insertion,
- stacking the second electronic board and the second metal part on the frame, so that the second electronic board is arranged between the second metal part and the frame 7,
- connecting the second metal part to the frame via the second group of fixing elements,
characterized in that connecting the second metal part to the frame via the second group of fixing element, comprises inserting the second group of fixing elements through the through holes of the second metal part along a second direction of insertion parallel to the first direction of insertion.

Solutions as described herein facilitate achieving a more efficient heat dissipation within the electronic unit.

In particular, a frame defining at least one channel in fluid communication with an environment external to the electronic unit enhances the dissipation of the heat released by the one or more modules.

One or more of the above features further enhances the dissipation of the heat released by the modules.

For instance, the metallic structure of the frame increases the conduction of the heat from the modules towards the at least one channel.

Moreover, providing a second ventilation device configured to force an airflow through the at least one channel enhances the convective heat transfer from the frame to the incident airflow.

Lastly, the provision of said platforms abutting the respective modules enlarges the contact surface between the modules and the frame, thereby improving the heat flow exiting the modules.

### Brief description of the figures

One or more embodiments will now be described, by way of example only, with reference to the annexed figures, wherein:
Figure 1A is a front perspective view of an electronic unit here described;
Fig 1B is a rear perspective view of an electronic unit of figure 1;
Figure 2 is an exploded view of an electronic unit of figure 1A;
Figure 3 is a top perspective view of a frame of the electronic unit here described;
Figure 4 is a bottom perspective view of a frame of the electronic unit here described;
Figures 5 to 7 are exploded views illustrating the mode of assembly of the electronic unit here described.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

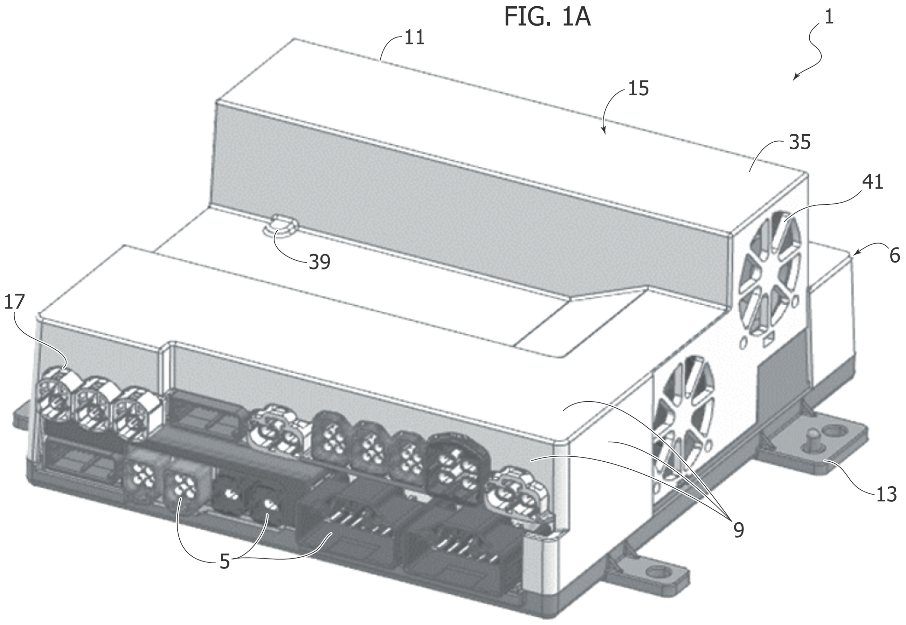

According to Figures 1A to 2, the reference number 1 refers to an electronic unit for a vehicle according to an embodiment of the present solution.

For instance, the aforesaid unit may be designed for controlling vehicle's cluster displays, HUD displays, central displays, passenger displays, loudspeakers and microphones.

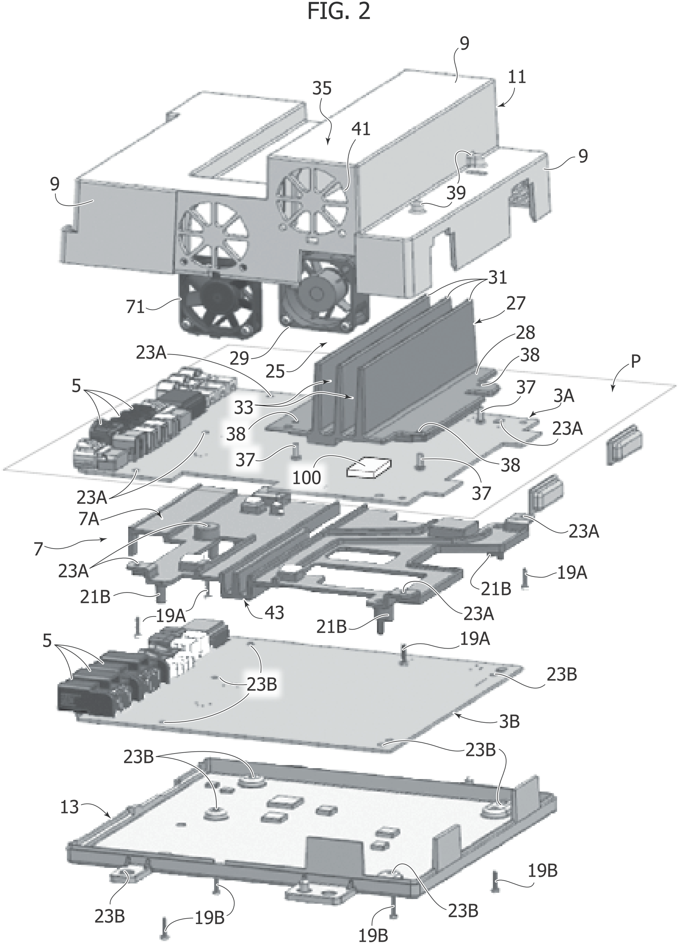

As known per se, the electronic unit 1 comprises at least one electronic module (indicated with the reference 100 in Figure 2). Preferably, the at least one electronic module 100 comprises one or more data-exchange modules configured to exchange data with systems external to the electronic unit 1, hereinafter referred to as peripherals of the vehicle. The electronic module 100 may also comprise one or more modules operating as processor modules, configured to process the data exchanged by the data-exchange modules.

In an example, the data exchanged by the data-exchange modules may include information or measurements regarding any device or appliance of the vehicle, such as data regarding the status of a component of the vehicle, or measurements acquired by sensors of the vehicle.

The data transfer or, more generally, the electrical connections within the electronic unit 1 are implemented by at least one electronic board configured to carry the aforesaid modules. With reference to figure 2 an exemplary electronic board is indicated with 3A.

In one or more embodiments, the electronic board 3A is a printed circuit board (PCB) per-se known.

In particular, the modules, indicated collectively by a single module 100, of the electronic unit 1 are firmly connected to the electronic board 3A according to any technology known by the person skilled in the art, for example by welding. In figure 2 the module 100, representative of one or more electronic modules, is shown in dashed line as it is fixed on the lower surface of the electronic board 3A.

In order to establish said electrical connection, the electronic board 3A extends substantially planar along a first plane P and has a layered structure comprising a central layer of insulating material, for instance glass fibre, stacked between two conductive layers, e.g. made of copper, arranged at opposite sides of the central layer.

The conductive layers of the electronic board 3A define a plurality of traces (not illustrated) extending throughout the electronic board 3A, thereby implementing the electrical connection between the modules of the electronic unit.

In various embodiments, the electronic board 3A may comprise a plurality of vias (not illustrated) extending along the width direction of the board 3A, configured to electrically connect the conductive layers of the board 3A.

As illustrated, the electronic unit 1 further comprises electric connectors 5 carried by the electronic board 3A, and arranged at peripheral portion thereof.

Such connectors 5 are provided with respective seats, each configured to receive a respective end connector carried by a connection wire associated with a peripheral of the vehicle, and are electrically connected to ends of the traces of the electronic board 3A.

Therefore, the provision of the connectors 5 implements the electrical connection between the modules, collectively indicated with 100, of the electronic unit 1 and the peripherals of the vehicle.

In a preferred embodiment shown in Figure 2, the electronic unit 1 comprises a first electronic board 3A, as discussed, and also a second electronic board 3B arranged parallel to each other.

In this embodiment, each electronic board 3A, 3B carries at least one of the electronic modules 100 of the electronic unit 1 and at least one connector 5.

As illustrated, the electronic unit 1 further comprises a supporting structure 6 comprising a frame 7, and at least a casing 15 comprising at least a first part 11, in particular a first sheet, designed or shaped so as to define one or more outer walls 9 of the casing 15 and thus of the electronic unit, and a second part 13, in particular a second sheet, designed or shaped so as to define further one or more of said outer walls 9.

Specifically, the first part 11 and the second part 13 are configured to cooperate with each other, thereby defining said outer casing 15 of the electronic unit 1.

Preferably, at least one of the first part 11 and second part 13 of the casing 15 are made of metallic material.

Even more preferably, both the first and the second parts 11, 13 of the casing 15 are made of metallic material.

In the embodiment shown in Figure 2, the frame 7 extends substantially parallel to plane P and defines a first and a second side 7A, 7B opposite to each other with respect to plane P.

Preferably, the frame 7 is arranged at an intermediate position between the first and the second electronic boards 3A, 3B so that, in an assembled configuration of the electronic unit 1, the frame 7 is stacked between the first and the second electronic boards 3A, 3B, wherein the first electronic board 3A and the second electronic board 3B face the first and the second sides 7A, 7B of the frame 7 respectively.

Preferably, the electronic modules of the electronic unit 1 are arranged between the respective electronic board 3A, 3B and the frame 7.

In other words, in the aforementioned assembled configuration of the electronic unit 1, each module is delimited along a direction orthogonal to plane P by the frame 7 and the respective electronic board 3A, 3B.

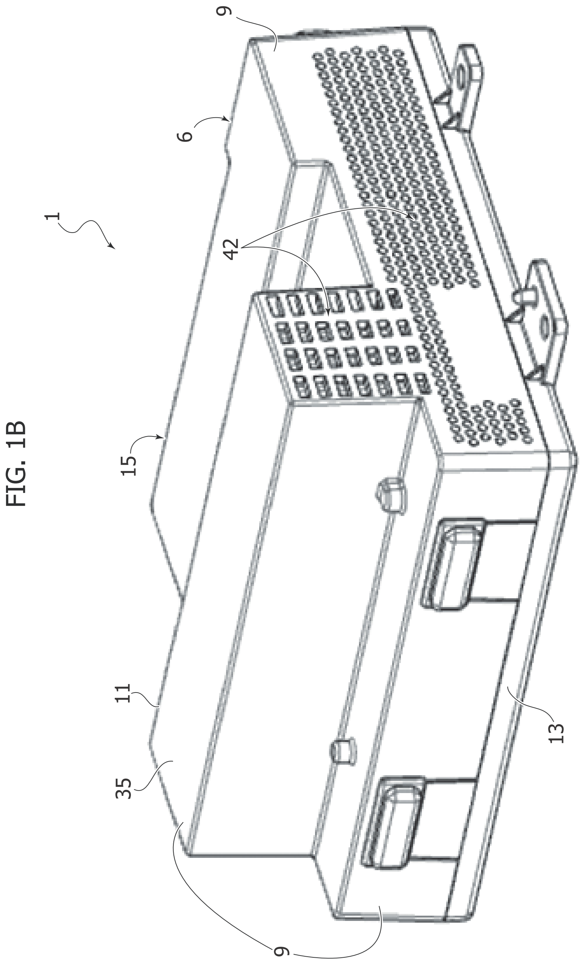

As shown in figures 1A and 1B, the outer casing 15 has an opening 17 arranged at one outer wall 9 thereof, configured to make the electric connectors 5 accessible from the outside of the electronic unit 1, for instance to be engaged by the aforesaid connection wires associated with the peripherals of the vehicle.

Preferably, the opening 17 of the outer casing 15 is shaped in such way to outline an external profile of the connectors 5.

In other words, on one hand the metal parts 11, 13 define the overall dimension of the electronic unit 1 and defines therewithin a housing for the other components of the electronic unit 1.

On the other hand, the frame 7 constitutes an internal skeleton configured to stiffen the structure of the electronic unit 1.

To this purpose, the metal parts 11, 13 and the electronic boards 3A, 3B are releasably connected to the frame 7 by means of a plurality of mutual engagement elements.

In the considered embodiment, the mutual engagement elements comprise fixing elements, e.g. screws, coupled to respective fixing formations, for instance via threaded coupling.

In particular, the fixing elements comprise a first group of fixing elements 19A extending through respective through holes 23A provided at peripherals portions of the frame 7 and on the first electronic board 3A, and engaging respective fixing seats 21A provided on the first metal part 11.

Similarly, the fixing elements further comprise a second group of fixing elements 19B extending through respective through holes 23B provided on the second metal part 11 and on the second electronic board 3B, and engaging respective fixing formations 21B provided at peripheral portion of the frame 7.

In various embodiments in accordance to Figure 2, the electronic unit 1 comprises a cooling system 25 configured to cool down the electronic modules during the operation of the electronic unit 1, and including a heatsink 27 and a ventilation device 29, e.g. a fan 29.

As known per se, the heatsink 27 comprises a base portion 28 configured to be fixed to the supporting structure 6 of the electronic unit 1, and a laminated portion 30 comprising a plurality of flaps 31 protruding from the base portion 28 and arranged parallel and spaced from each other, thereby defining a plurality of channels 33.

As illustrated, the heatsink 27 is arranged at an intermediate position between the first electronic board 3A and the first metal part 11 and is oriented in such way that the channels 33 extend parallel to plane P.

In particular, in an assembled configuration of the electronic unit 1, the heatsink 27 is received within a recess 35 arranged on the first metal part 11, and the base portion 28 of the heatsink 27 is releasably connected to the first metal part 11.

Specifically, the connection of the base portion 28 of the heatsink 27 to the first metal part 11 is realized by means of connecting elements 37 extending through respective fixing holes 38 arranged on the base portion 28 and engaging respective fixing seats 39 provided on the first metal part 11.

Referring to the cooling system 25, the ventilation device 29 is arranged facing the channels 33 defined by the flaps 31 of the heatsink 27, and is configured to force an air flow therethrough in order to induce a convective heat transfer between the flaps 31, having a higher temperature due to the heat released by the electronic module, and fresh air forced into the electronic unit 1.

As illustrated, the first metal part 11 comprises a through aperture 41 arranged on an outer wall 9 of the casing 15 putting into fluid communication the ventilation device 29 and an environment external to the electronic unit 1.

In various embodiments, an outer wall 9 different from, preferably opposite to, to the outer wall 9 having the aperture 41 may comprise a punctured portion 42 (illustrated in figure 1B) for the outflow of the air exiting the channels 33 of the heatsink 27.

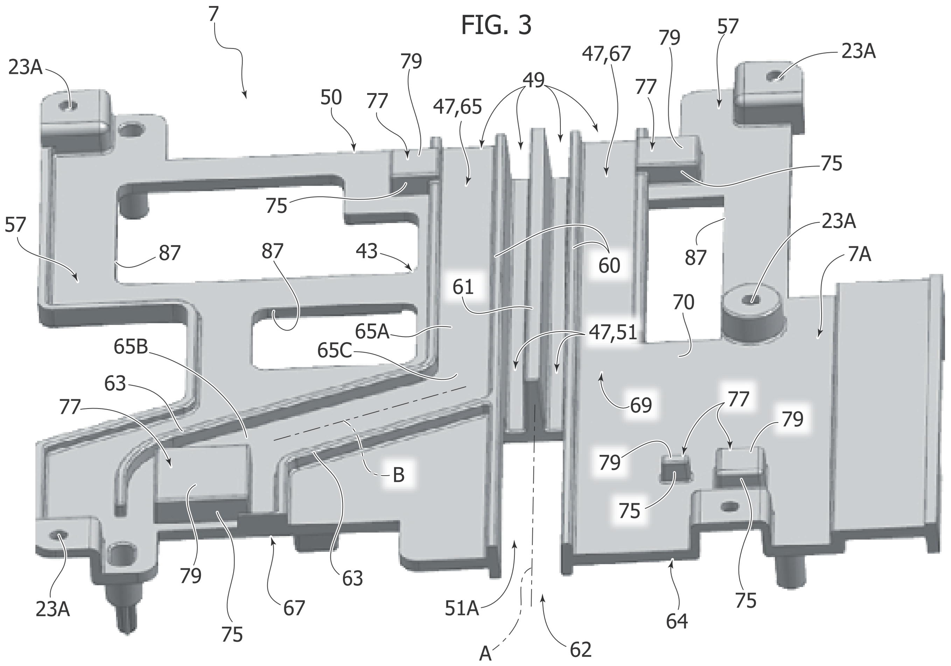

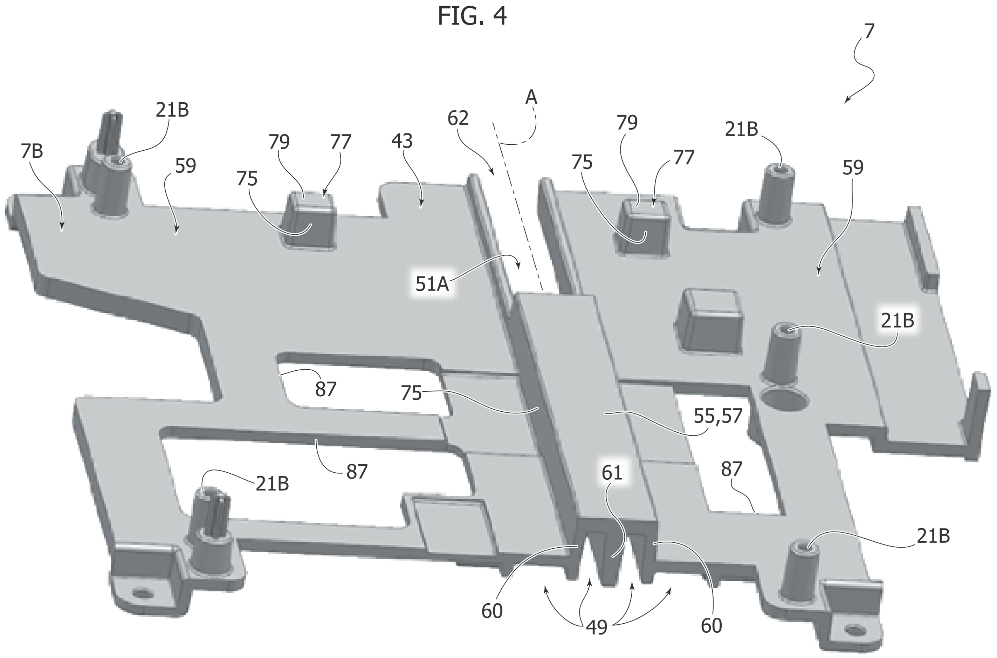

In accordance with the present solution, referring to Figures 3 and 4, the frame 7 comprises a shaped portion 43 defining a second heatsink 45.

Specifically, the shaped portion 43 of the frame 7 defines at least one channel 47 configured to convey an air flow therethrough so as to cool down the electronic modules of the electronic unit 1.

In various embodiments, the at least one channel 47 of the shaped portion 43 comprise a plurality of channels 47 extending substantially parallel to plane P.

In particular, each channel 47 extends from a respective inlet port 49 arranged in fluid communication with the environment external to electronic unit 1.

Preferably, the inlet port 49 of each channel 47 is arranged on a same edge 50 of the frame 7, referring with the term "edge" to a peripheral portion of the frame 7, namely a border of the frame 7.

In the embodiment shown in Figure 3 and 4, the channels 47 are arranged on a same side of the frame 7, namely the first side 7A. However, the channels 47 of the shaped portion 43 may be provided on any side 7A, 7B of the frame 7, as well as on both sides thereof.

In the considered embodiment, the channels 47 comprise a pair of central channels 51 extending substantially linear from the respective inlet port 49 along a first direction A.

More in detail, the central channels 49 extend within a recessed portion 53 arranged within the frame 7.

As shown in Figure 3 and 4, the recessed portion 53 comprises a bottom wall 55 extending parallel to plane P and arranged offset with respect to surfaces 57, 59 defined by the first and the second side 7A, 7B of the frame respectively.

Specifically, the recessed portion 53 is such that the bottom wall 55 is retracted with respect to the surface 57 of the frame 7, and is protruding with respect to the surface 59 of the frame 7.

In the considered embodiment, the recessed portion 53 further comprises a pair of lateral ribs 60 connecting the bottom wall 55 to the surface 59 of the frame 7, and a third rib 61 extending parallel to the two lateral ribs 60 at an intermediate position therebetween, thereby defining the two central channels 51.

In one embodiment, the third rib 61 has an extension along the first direction A smaller than the lateral ribs 60 so that the two central channel 51 merge into a single channel 51A having an outlet port 62 arranged peripherally with respect to the frame 7 at a second edge 64 of the frame 7.

Preferably, the second edge 64 of the frame 7 is arranged opposite to the edge 50 associated with the corresponding inlet port 49 with respect to the frame 7.

In various embodiments, the shaped portion 43 of the frame 7 comprises reinforcing ribs 63 extending along the surfaces 57, 59 of the frames 7 and protruding with respect thereto.

As shown in Figure 3, in one embodiment, a first pair of reinforcing ribs 63 defines a third channel 65 extending from the respective inlet port 49 to an outlet port 67 arranged, as well as the central channel 51A, at the edge 64 of the frame 7.

Incidentally, the outlet ports 62, 67 of the channels 51A, 65 respectively are arranged facing the punctured portion of the outer casing 15 so that the incident airflow flowing through the channels 51A, 65 can be outflowed directly towards the outside of the electronic unit 1.

In the embodiment shown in figure 3, the third channel 65 comprise an upstream portion 65A extending substantially parallel to the first direction A, alongside the central channel 51 and a downstream portion 65B extending along a second direction B incident with respect to the first direction A, and connected to the upstream portion 65A by means of an elbow portion 65C.

In one embodiment, the shaped portion 43 further comprises a fourth channel 67 delimited laterally by a ridge 63 of the frame 7 on one side and by one of the aforesaid lateral ribs 60 of the recessed portion 53 on the other side.

As illustrated, the fourth channel 67 extends parallel to the first direction A from the respective inlet port 49 to an outlet port 69 arranged retracted with respect to the edge 64 of the frame 7, so that the airflow conveyed by the channel 67 flows into a portion 70 of the surface 57, 59 of the frame 7.

Summarizing, the channels 47 have substantially a U-shaped cross section delimited laterally by the ribs 60, 61 and/or by the ridges 63, and delimited at the bottom by the bottom wall 55 or by the surface 57, 59 of the frame 7.

Accordingly, in an assembled configuration of the electronic unit 1, the open side of each channel 47 faces a respective electronic board 3A, 3B so that the modules carried by the electronic boards 3A, 3B are directly exposed to the air flowing within the channels 47.

Also, it is underlined that for each channel 47 - which on the frame 7 is an open channel, i.e., the boundary of the channel 47 in an unassembled state seen in cross section is not a solid and rigid boundary (the cross section is just C-shaped or U-shaped, with the open side facing the electronic board 3A - in assembled configuration the surfaces of the electronic boards 3A, 3B facing the channels 47 substantially form a wall of the channels 47 so that such channels 47 take the form of ducts or conduits. Thus, in assembled state, the channels 47 with the board 3A identify a conduit for the flow of the air, in particular from a side to an opposite side of the casing 15.

In other words, in an assembled configuration of the electronic unit 1, the electronic board 3A, 3B cooperates with the ribs 60,61, the ridges 63, the bottom wall 55 and the surface 57, 59 of the frame 7 so as to form a closed conduit, referring with the term closed conduit to a channel delimited by solid walls along any direction.

In various embodiments of the present solution, the electronic unit 1 comprises a second cooling system including the second heatsink defined by the channels 47 of the frame 7 and a second ventilation device 71, e.g. a second fan 29 associated thereto.

As illustrated in Figure 2, similarly to the first ventilation device 29 of the first cooling system 25, the second ventilation device 71 is arranged facing the inlet ports 49 of the channels 47 in order to force an air flow therethrough.

In particular, the second ventilation device 71 is in fluid communication with the environment external to the electronic unit by means of a through aperture 73 arranged on an outer wall 9 of the casing 15.

According to Figure 1A, in one embodiment, the first and the second ventilation devices 29, 71 are arranged side by side or, in other words, both the first and the second ventilation devices 29, 71 face the same outer wall 9 of the outer casing 15.

As illustrated in Figure 3 and 4, in various embodiments, the frame 7 is provided with a plurality of platforms 75 protruding with respect to the surfaces 57, 59 of the frame 7.

In particular, the platforms 75 define respective contact surfaces 77, preferably a flat contact surfaces 77, configured to abut respective electronic module in an assembled configuration of the electronic unit 1 in order to exchange heat therewith.

In the example shown in figure 4, the recessed portion 53 may also function as a further platform 75, wherein the bottom wall 55 defines a further contact surface configured to abut one or more modules carried by the second electronic board 3B.

Accordingly, the provision of the contact surfaces 77 enhances the conductive heat exchange between the electronic modules and the frame 7 during operation of the electronic unit 1.

In one embodiment, each platform 75 may be provided with a thermal pad 79 at a free end thereof. The thermal pad 79 defines the aforesaid contact surface 77 and is preferably made of a material having a stiffness lower than the material constituting the frame 7 in order to achieve a better adhesion between the platform and the respective module.

As a matter of fact, when manufacturing the frame 7, the contact surface 77 may comprise surface defects resulting in a not perfectly flat surface, which may lead to a non-uniform contact with the respective module. Similarly, surfaces of the electronic modules facing the platforms 75 may not be perfectly flat.

Therefore, a local yielding of the thermal pads 79 ensures a uniform contact surface, thus a more effective heat transfer from the modules to the platforms 75.

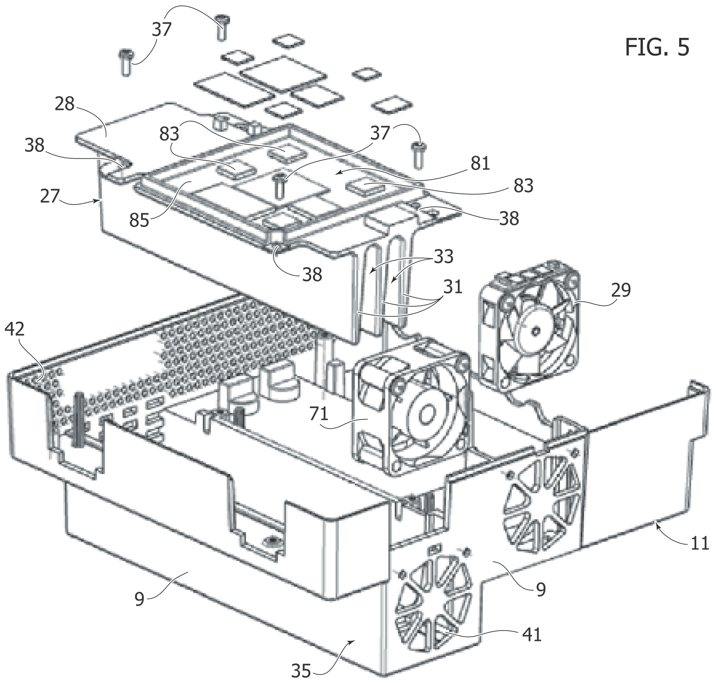

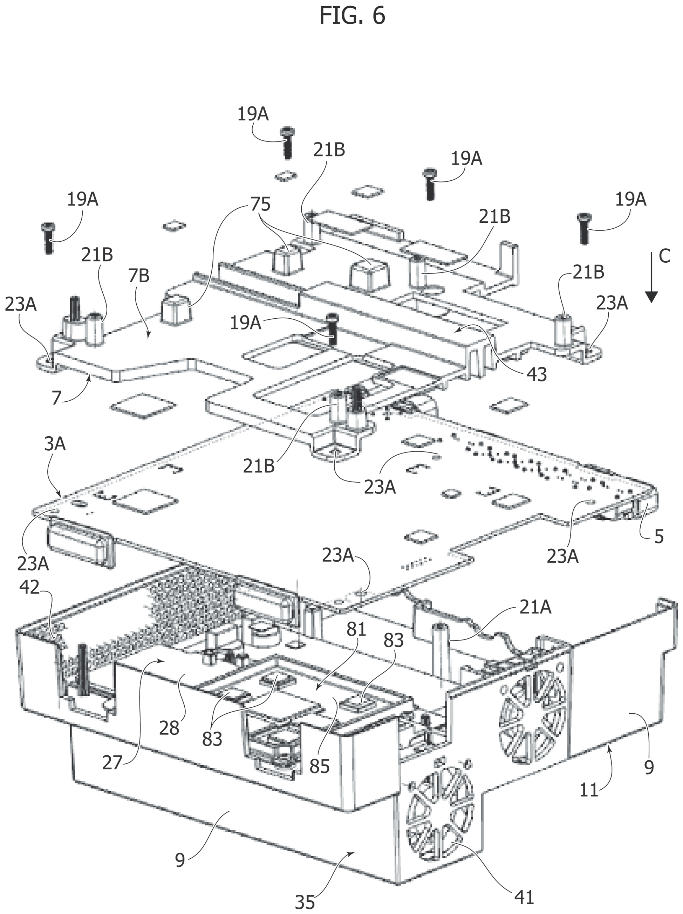

In one embodiment, the base portion 28 of the heat sink 27 may comprise a recessed portion 81 (illustrated in Figures 5 and 6) provided with at least one platform 83.

The platforms 83 of the base portion 28 of the heat sink 27 are similar to the platforms 75 of the frame 7 described above. Accordingly, the same considerations made for platforms 75 remain valid for the platforms 83.

In particular, the platforms 83 protrude from a bottom surface 85 of the recessed portion 81 of the base portion 28, so that, in an assembled configuration of the electronic unit, the platforms 83 abut respective modules 100 arranged at an intermediate position between the first electronic board 3A and the heatsink 27.

In one embodiment, the frame is made of a heat conductive material, such as a metallic material. Preferably, the frame 7 is made of Aluminium or Magnesium alloy.

The frame 7 can be manufactured using any technology known to the person skilled in the art, e.g. via diecasting or metal sheet stamping.

A metallic composition of the frame 7 plays a major advantage in dissipating heat released within the electronic unit 1.

Indeed, making a metallic frame 7 non only enhances the heat transfer from the modules to the platforms 75 through the contact surfaces 77, but also enhances the heat exchange between the channels 47 and the incident airflow conveyed therethrough.

As illustrated in Figure 3 and 4, in various embodiments, the frame 7 may comprise at least one through aperture 87 configured to perform the dual function of, on the one hand, lightening the frame 7, especially in the case it is made of metallic material, and, on the other hand, providing a seat for modules of the electronic unit 1 protruding from the electronic boards 3A, 3B beyond the respective surface 57, 59 of the frame 7 facing thereto.

Referring to Figures 5 to 7, described hereinafter is a method for assembling the electronic unit 1 according to the present solution.

In particular, the method for assembling the electronic unit 1 comprises a first step (illustrated in Figure 5) including arranging the heatsink 27 of the first cooling system 25 within the recess 35 of the first metal part 11 and connecting it by means of the connecting elements 37.

At the same time, the first and the second ventilation devices 29, 71 are fixed to the outer wall 9 in any suitable manner, e.g. via screws.

A further step of the assembling method (illustrated in Figure 6) comprises arranging the first electronic board 3A so as to bring into abutment the electronic board 3A against the base portion 28 of the heatsink 27.

Subsequently, the frame 7 is arranged so that the platforms 75 provided on the first side 7A of the frame 7 abut respective modules carried by the electronic board 3A.

In other words, in an assembled configuration of the frame 7, the electronic board 3A is delimited by the heatsink 27 and the first metal part 11 on one side, and by the frame 7 on the other side.

In this phase, the frame 7 is connected to the first electronic board 3A and the first metal part 11 by means of the first group of fixing elements 19A.

In particular, as described before in the present disclosure, the fixing elements 19A extend through respective through holes 23A of the frame 7 and the first electronic board 3A and engage respective fixing seats 21A provided on the first metal part 11.

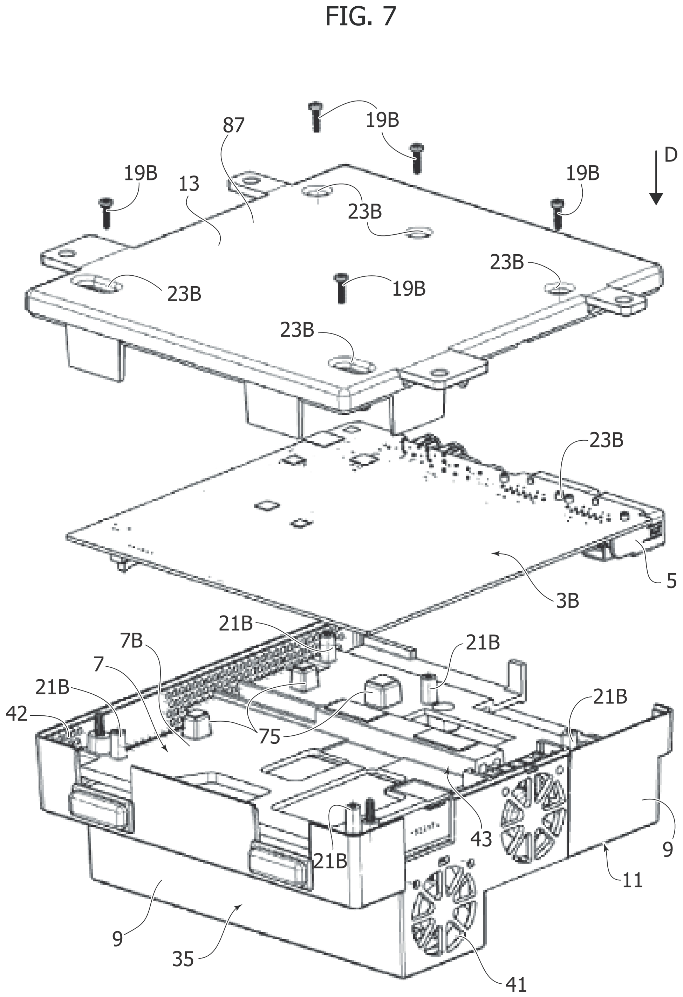

Specifically, during the connection step of the frame 7 to the first metal part 11, the first group of fixing elements 19A is inserted from the second side 7B of the frame 7 through the respective through holes 23A, along a direction of insertion (indicated with the arrow C in Figures 6 and 7).

Referring to Figure 7, a further step of the assembling method comprises arranging the second electronic board 3B so that the respective modules carried thereby abut the platforms 75 of the second side 7B of the frame 7.

Subsequently, the second metal part 13 is connected to the frame 7 by means of the second group of fixing elements 19B in order to define together with the first metal part 11 the outer casing 15 and housing the frame 7, the electronic boards 3A, 3B and the cooling systems therewithin.

In particular, as described before in the present disclosure, the fixing elements 19B extend through respective through holes 23B of the second metal part 13 and the second electronic board 3B and engage respective fixing seats 21B provided on the frame 7.

Similarly to the first group of fixing elements 19A, during the connection step of the second metal part 13 to the frame 7, the second group of fixing elements 19B is inserted from an external surface 87 of the second metal part 13 - corresponding to the base surface of the electronic unit 1 in the assembled configuration - through the respective through holes 23 B, along a second direction of insertion D, parallel to the first direction of insertion C.

Thus, based on the above, the solution here described refers to a method for assembling an electronic unit, e.g., 1, as described previously, the method comprising:
- providing a first metal part, e.g., 11,
- stacking said first electronic board, such as the board 3A and said frame, e.g., 7, on said first metal part, so that said first electronic board, e.g., 3A, is arranged between said first metal part, e.g., 11, and said frame, e.g., 7,
- connecting said frame, e.g., 7, to said first metal part, e.g., 11, via said first group of fixing elements, e.g., 19A,
   wherein connecting said frame, e.g., 7, to said first metal part, e.g., 11, comprises inserting said first group of fixing elements, e.g., 19A, through said through holes, e.g., 23A, of the frame, e.g., 7, along a first direction of insertion, e.g., C,
- stacking said second electronic board, e.g., 3B, and said second metal part, e.g., 13, on said frame, e.g., 7, so that said second electronic board, e.g., 3B, is arranged between said second metal part, e.g., 13, and said frame, e.g., 7,
- connecting said second metal part, e.g., 13, to said frame, e.g., 7, via said second group of fixing elements, e.g., 19B.

In such method connecting said second metal part, e.g., 13, to said frame, e.g., 7, via said second group of fixing elements, e.g., 19B, comprises inserting said second group of fixing elements, e.g., 19B, through said through holes, e.g., 23B, of said second metal part, e.g., 13, along a second direction of insertion D parallel to said first direction of insertion C.

It should be noted that, although the assembling method described hereabove refers to the assembly of the electronic unit 1 having the structure described according to the present solution, in particular comprising a shaped portion, e.g. 43, with a further heatsink, e.g., 45, to provide heat exchange with the electronic module, e.g., 100, such said shaped portion comprising at least one channel, such as 47, or 51, 65, 67, in fluid communication with an environment external to the casing, e.g., 15, of the electronic unit, the same method can be carried out in order to assemble any electronic unit including a frame, such as frame 7, provided with through holes, such as 23A, for connecting the frame 7 to the first metal part, e.g., 11, via the first group of fixing elements 19A, and with the fixing seats 21B for connecting the second metal part 13 to the frame 7.As can be inferred, the assembling method according to the solution here described can be carried out regardless of the geometry of the frame 7 described herein, in particular regardless of the presence or geometry of the shaped portion 43 of the frame 7.

Thus, solutions as described herein enhance the dissipation of the heat released by the electronic modules during operation of the electronic unit 1.

In particular, as known by the person skilled in the art, effective technologies to enhance heat dissipation from a body comprise:
- enlarging the surface of the body exposed to a colder medium, e.g. air, water, a second body, in order to increase the heat flow through the surface itself,
- when manufacturing the body, using thermally conductive materials, such as metallic material,
- exposing the body to an incident flow of a refrigerating fluid, e.g. air or water, thereby enhancing the convective heat exchange between the body and the incident flow.

As can be understood by the preceding description, the present solution implements all the above technologies in order to enhance heat dissipation within the electronic unit 1 with respect to known solutions.

In particular, providing a frame 7 having the shaped portion 43 defining the second heatsink 45 allows to enlarge the surface of the frame 7 and, at the same time, allows to define channels for receiving fresh air coming from the outside of the electronic unit 1.

Such advantages are further fostered by providing the second ventilation device 71, which forces an airflow through the channels 47 of the frame 7, thereby contributing to the convective heat transfer from the frame 7 to the incident airflow.

Furthermore, using a metallic material, such as Aluminium or Magnesium alloys, as the constituting material of the frame 7 enhances the absorption of the heat released by the modules by the frame 7.

The conductive heat transfer from the modules to the frame 7 is further enhanced by the provision of the platforms 75 protruding from the surfaces 57, 59 of the frame 7 and abutting the modules of the electronic unit 1.

Another advantage of the present solution relates to the sustainability of the manufacturing of the electronic unit 1.

As a matter of fact, using a metallic material also as the constituting material of the first and second parts 11, 13 of the casing 15 reduces the need for plastic components, thereby facilitating a more sustainable production, as well as a more sustainable end of life disposal of the electronic unit 1.

A further advantage of the present solution lies in the simplicity of the assembling method of the electronic unit 1.

Indeed, due to the first and the second group of fixing elements 19A, 19B being insertable along respective directions of insertion C, D parallel to each other, the assembling of the electronic unit 1 can be performed by simply stacking one on another the first metal part 11, the first electronic board 3A, the frame 7, the second electronic board 3B and the second metal part 13 according to the assembling method described herein, without the need for overturning the electronic unit during intermediate steps of the assembling process.

Moreover, the fact that each electronic board 3A and/or 3B and each metal part 11, 13 constituting the outer casing 15 are connected to the frame 7 either via the first or the second group of fixing elements 19A, 19B, make the frame 7 itself a reference member when assembling the electronic unit 1, thereby assuring the correct positioning of the aforesaid components.

In other words, the frame 7 according to the present solution enables the assembling of the electronic unit 1 without the need for further reference elements, which would require a chain dimensioning of the components, resulting in wider geometric tolerances.

Without prejudice to the underlying principles, the details and the embodiments may vary, even significantly, with respect to what has been described by way of example only without departing from the scope of the embodiments.

The extent of protection is determined by the annexed claims.

## Claims

1. An electronic unit (1) for vehicles, comprising a casing (15) housing therewithin:
- at least one electronic module (100),
- at least one electronic board (3A, 3B) carrying said at least one electronic module (100),
- a frame (7) releasably connected to said at least one board (3A, 3B),
- a first cooling system (25) configured to cool down said at least one electronic module (100), comprising a heatsink (27) and a ventilation device (29) configured to convey an air flow through said heatsink (27),
**characterized in that** said frame (7) comprises a shaped portion (43) defining a second heatsink (45) configured to provide heat exchange with said at least one electronic module (100),
wherein said shaped portion (43) of the frame (7) defining said second heatsink (45) comprises at least one channel (47; 51, 65, 67) in fluid communication with an environment external to said casing (15) of the electronic unit (1).

2. The electronic unit according to claim 1, wherein said frame (7) is made of metallic material, preferably Aluminium or Magnesium alloy.

3. The electronic unit according to claim 1, comprising a second cooling system including said shaped portion (43) defined by said frame (7) and a second ventilation device (71) associated therewith, the second ventilation device (71) being configured to convey an air flow through said at least one channel (47) defined by said frame (7).

4. The electronic unit according to claim 3, wherein said at least one channel (47) defined by said frame (7) includes an inlet port (49) in fluid communication with an environment external to the electronic unit (1),
said inlet port (49) being arranged facing said second ventilation device (71) so as to receive said air flow conveyed by said second ventilation device (71),
said at least one channel (47) comprising an outlet (67, 62) port arranged in fluid communication with an environment external to the electronic unit (1),
said outlet port (67, 62) being arranged downstream with respect to said inlet port (49), and configured for the exhaust of said air flow conveyed therethrough towards the outside of said electronic unit (1).

5. The electronic unit according to claim 1, wherein said at least one channel (47; 51, 65, 67) is an open channel having a substantially U-shaped geometry.

6. The electronic unit according to claim 5, wherein said frame (7) comprises:
- at least one surface (55, 57, 59),
- at least one rib (60) and/or at least one ridge (63) protruding with respect to said surface (55, 57, 59),
said at least one rib (60) and/or at least one ridge (63) and said surface (55, 58, 59) delimiting said at least one channel (47; 51, 65, 67) laterally and at the bottom respectively, thereby defining said substantially U-shaped geometry of the at least one channel (47; 51, 65, 67).

7. The electronic unit according to claim 6, wherein said at least one channel (47; 51, 65, 67) comprises an open side configured to face said at least one electronic board (3A, 3B),
wherein, in an assembled configuration of said electronic unit (1), said at least one electronic board (3A, 3B) cooperates with said at least one rib (60) and/or at least one ridge (63), and with said surface (55, 58, 59) so as to form a conduit therewith.

8. The electronic unit according to claim 1, wherein said at least one electronic board (3A, 3B) comprises a first and a second electronic board (3A, 3B) arranged at opposite sides (7A, 7B) of said frame (7).

9. The electronic unit according to claim 8, wherein said frame (7) comprises at least one platform (75),
said at least one platform (75) defining a contact surface (77) configured to abut a respective module of said at least one module in an assembled configuration of the electronic unit (1).

10. The electronic unit according to claim 9, wherein said platform (75) comprises a thermal pad (79) arranged on a free end thereof, said thermal pad (79) defining said contact surface (77).

11. The electronic unit according to any of the preceding claims, wherein said casing (15) comprises a first metal part (11) and a second metal part (13), each metal part (11, 13) being releasably connected to said frame (7).

12. The electronic unit according to claim 11, wherein said first and second electronic boards (3A, 3B), said first and second metal parts (11, 13) are releasably connected to said frame (7) by means of a plurality of fixing elements (19) arranged at peripheral portions of said frame (7).

13. The electronic unit according to claim 12, wherein said plurality of fixing elements (19) comprises:
- a first group of fixing elements (19A) configured to connect said first electronic board (3A) and said first metal part (11) to said frame (7),
the first group of fixing elements (19A) extending through respective through holes (23A) arranged on the frame (7) and on the first electronic board (3A) and engaging respective fixing seats (21A) arranged on said first metal part (11),
- a second group of fixing elements (19B) configured to connect said second electronic board (3B) and said second metal part (13) to said frame,
the second fixing elements (19B) extending through respective through holes (23B) arranged on the second metal part and on the second electronic board (3B), and engaging respective fixing seats (21B) arranged on said frame (7).

14. The electronic unit according to any of the previous claims, wherein said electronic module (100) comprises a module configured to exchange data with systems external to the electronic unit (1) and/or process said data

15. A method for assembling an electronic unit (1) according to any of claims 12 to 14, the method comprising:
- providing a first metal part (11),
- stacking said first electronic board (3A) and said frame (7) on said first metal part, so that said first electronic board (3A) is arranged between said first metal part (11) and said frame (7),
- connecting said frame (7) to said first metal part (11) via said first group of fixing elements (19A),
wherein connecting said frame (7) to said first metal part (11) comprises inserting said first group of fixing elements (19A) through said through holes (23A) of the frame (7) along a first direction of insertion (C),
- stacking said second electronic board (3B) and said second metal part (13) on said frame (7), so that said second electronic board (3B) is arranged between said second metal part (13) and said frame (7),
- connecting said second metal part (13) to said frame (7) via said second group of fixing elements (19B), **characterized in that** connecting said second metal part (13) to said frame (7) via said second group of fixing elements (19B), comprises inserting said second group of fixing elements (19B) through said through holes (23B) of said second metal part (13) along a second direction of insertion D parallel to said first direction of insertion C.
